# DEMANDE DE BREVET EUROPEEN

(11) **EP 1 087 343 A1**
(43) Date de publication de la demande: **28.03.2001**
(21) Numéro de dépôt: 00402551.6
(22) Date de dépôt: 15.09.2000
(51) Int. Cl.: G07C 5/00

(54) **Procédé et dispositif de diagnostic véhicule à distance par reseau de communication**

(30) Priorité: 24.09.1999 FR 9911935
(71) Demandeur: Renault, 92100 Boulogne Billancourt (FR)
(72) Inventeur: Legay, Pierre, 92100 Boulogne Billancourt (FR); Marichalar, Simon, 92190 Meudon (FR)

(57) **Abrégé**

Procédé de diagnostic d'un véhicule (10) par un système expert (11) situé à distance, le véhicule (10) comportant au moins un calculateur (16,17,18) possédant un microprocesseur et une zone de mémoire, le microprocesseur étant adapté pour détecter une anomalie lors de son fonctionnement et stocker des données, représentatives de ladite anomalie, dans la zone de mémoire, le calculateur (16,17,18) comportant en outre des moyens d'interface pour l'échange de données avec un bus diagnostic (15), le véhicule (10) comportant en outre des premiers moyens d'émission et de réception de signaux (13), le système expert (11) comportant un calculateur relié à des seconds moyens d'émission et de réception, caractérisé en ce que le procédé comprend les étapes suivantes :
- l'interrogation par un calculateur de diagnostic (14), monté sur le véhicule (10), du calculateur (16,17,18) équipant le véhicule via le bus diagnostic (15),
- la transmission des données représentatives de l'anomalie détectée par le calculateur (16,17,18), au calculateur de diagnostic (14), via le bus diagnostic (15),
- l'établissement d'une communication entre le calculateur de diagnostic (14) et le système expert (11) par le biais des premier (13) et second moyens d'émission et de réception de signaux,
- la transmission des données, par le calculateur de diagnostic (14), au système expert (11), via les premier (14) et second moyens d'émission et de réception de signaux,
- l'élaboration d'un diagnostic par le système expert (11) à partir desdites données.

## Description

La présente invention se rapporte au domaine technique des diagnostics réalisés sur des véhicules automobiles.

Plus particulièrement, elle concerne un procédé de diagnostic d'un véhicule par un système expert situé à distance, le véhicule comportant au moins un calculateur possédant un microprocesseur et une zone de mémoire, le microprocesseur étant adapté pour détecter une anomalie lors de son fonctionnement et stocker des données, représentatives de ladite anomalie, dans la zone de mémoire, le calculateur comportant en outre des moyens d'interface pour l'échange de données avec un bus diagnostic, le véhicule comportant en outre des premiers moyens d'émission et de réception de signaux, le système expert comportant un calculateur relié à des seconds moyens d'émission et de réception.

Les véhicules actuels sont équipés de nombreux calculateurs, tel le calculateur moteur ou le calculateur habitacle, susceptibles de réaliser un auto-diagnostic et de conserver en mémoire leurs défauts et de les transmettre via un bus de diagnostic. L'interrogation de ces calculateurs est réalisée au moyen d'un terminal que l'on relie directement au bus diagnostic afin de lire les différents défauts mémorisés par les calculateurs. Le terminal, à partir des différentes données interrogées, est capable d'émettre un diagnostic quant à l'origine d'une éventuelle panne du véhicule.

Cette opération nécessite la présence du véhicule sur un lieu où peut être effectuée l'interrogation des calculateurs via le bus diagnostic. Or, il peut être particulièrement avantageux de pouvoir réaliser un diagnostic du véhicule à distance, c'est-à-dire lorsque le véhicule tombe en panne dans un lieu où un diagnostic traditionnel ne peut être entrepris. En effet, un tel diagnostic à distance permettrait au service de réparation d'arriver sur les lieux de la panne avec, par exemple, directement la bonne pièce à changer.

Le document US 5 781 871 décrit un procédé de remontées d'informations, en l'espèce des valeurs de seuils pour des calculateurs de moteur de véhicules, issues de plusieurs véhicules d'un même type, vers un centre de calcul pouvant être situé à distance, qui établit à partir des différentes valeurs, divers calculs statistiques, afin de déterminer une nouvelle valeur de seuil. Cette nouvelle valeur de seuil peut être transmise par le centre de calcul aux calculateurs des véhicules afin de remplacer les anciennes valeurs de seuil.

Le procédé, décrit dans le document US 5 781 871, correspond bien à l'envoi d'informations mémorisées sur un véhicule vers un centre de traitement à distance via un lien de communication. Toutefois, il est orienté davantage vers la maintenance d'une flotte de véhicule, puisqu'il permet l'analyse statistique d'un même type de données issu d'une même famille de véhicules, en vue éventuellement d'y apporter certaines corrections.

Le présent procédé ne permet pas l'interrogation par le centre de traitement du ou des différents calculateurs d'un même véhicule, en particulier dans le cas où les informations données par ces calculateurs sont insuffisantes pour l'établissement d'un diagnostic. Il ne permet pas au centre de traitement de faire appel à des fonctions diagnostic du ou des calculateurs du véhicule pour récupérer une donnée bien précise.

La présente invention vise à réaliser le diagnostic d'une panne survenue sur un véhicule, à partir des informations mémorisées par les différents calculateurs équipant le véhicule, par un système expert situé à distance.

Dans ce but, elle propose un procédé de diagnostic d'un véhicule par un système expert situé à distance comprenant les étapes suivantes :
- l'interrogation par un calculateur de diagnostic, monté sur le véhicule, du calculateur équipant le véhicule via le bus diagnostic,
- la transmission des données représentatives de l'anomalie détectée par le calculateur, au calculateur de diagnostic, via le bus diagnostic,
- l'établissement d'une communication entre le calculateur de diagnostic et le système expert par le biais des premier et second moyens d'émission et de réception de signaux,
- la transmission des données, par le calculateur de diagnostic, au système expert, via les premier et second moyens d'émission et de réception de signaux,
- l'élaboration d'un diagnostic par le système expert à partir desdites données.

Selon une autre caractéristique de l'invention, le procédé de diagnostic comprend, en outre, les étapes suivantes :
- la transmission par le système expert d'une requête au calculateur de diagnostic, via les premier et second moyens d'émission et réception de signaux, afin d'interroger le calculateur équipant le véhicule pour obtenir des données spécifiques complémentaires,
- l'interrogation par le calculateur de diagnostic du calculateur via le bus diagnostic,
- la transmission par le calculateur, au calculateur de diagnostic, des données spécifiques complémentaires via le bus diagnostic,
- la transmission des données spécifiques complémentaires par le calculateur de diagnostic au système expert via les premier et second moyens d'émission et de réception de signaux.

Selon une autre caractéristique de l'invention, le procédé comprend, en outre, les étapes suivantes :
- la demande de données spécifiques complémentaires, par le système expert, au calculateur de diagnostic, via les premier et second moyens d'émission et de réception de signaux;
- la transmission de cette demande au conducteur du véhicule, au moyen d'une interface homme/machine,
- la transmission, via les premier et second moyens d'émission et de réception de signaux, au système expert, des données spécifiques complémentaires entrées par le conducteur au moyen de l'interface homme/machine.

Selon une autre caractéristique de l'invention, le calculateur de diagnostic n'interroge le calculateur pour récupérer les données relatives à des anomalies de fonctionnement et/ou des données complémentaires que lorsque la communication entre le calculateur de diagnostic et le système expert est établie.

Selon une autre caractéristique de l'invention, le calculateur diagnostic peut interroger un calculateur pour récupérer les données relatives à des anomalies de fonctionnement, et/ou des données complémentaires, à tout moment.

Selon une autre caractéristique de l'invention, l'établissement de la communication, entre le calculateur de diagnostic et le système expert, est établi par le conducteur du véhicule.

Selon une autre caractéristique de l'invention, l'établissement de la communication, entre le calculateur de diagnostic et le système expert, est établi par le système expert.

Selon une autre caractéristique de l'invention, l'établissement de la communication, entre le calculateur de diagnostic et le système expert, est établi par le calculateur de diagnostic.

L'invention propose aussi un dispositif de diagnostic d'un véhicule, le véhicule comportant au moins un calculateur possédant un microprocesseur et une zone de mémoire, le microprocesseur étant adapté pour détecter une anomalie lors de son fonctionnement et stocker des données, représentatives de ladite anomalie, dans la zone de mémoire, le calculateur comportant en outre des moyens d'interface pour l'échange de données avec un bus diagnostic, caractérisé en ce qu'il comprend un calculateur de diagnostic relié d'une part au calculateur via le bus diagnostic, et d'autre part à des moyens d'émission et de réception de signaux, et adapté pour recevoir les données issues du calculateur, via le bus diagnostic, et les configurer pour les émettre par les moyens d'émission et de réception, et adapté pour recevoir des signaux reçus par les moyens d'émission de réception et de les configurer en demande de données complémentaires qu'il transmet, via le bus diagnostic, au calculateur.

Selon une autre caractéristique de l'invention, le calculateur de diagnostic est, en outre, relié à des moyens d'interface homme machine par lesquels le conducteur du véhicule peut envoyer les données complémentaires suite à une demande du calculateur de diagnostic.

D'autres caractéristiques et avantages de l'invention apparaîtront à la lecture de la description qui va suivre en référence aux dessins annexés dans lesquels :
- la figure 1 représente schématiquement le principe de réalisation d'un diagnostic à distance selon l'invention,
- la figure 2 représente schématiquement le dispositif selon l'invention équipant un véhicule,
- la figure 3 représente une première variante du dispositif selon l'invention,
- la figure 4 représente une seconde variante du dispositif selon l'invention.

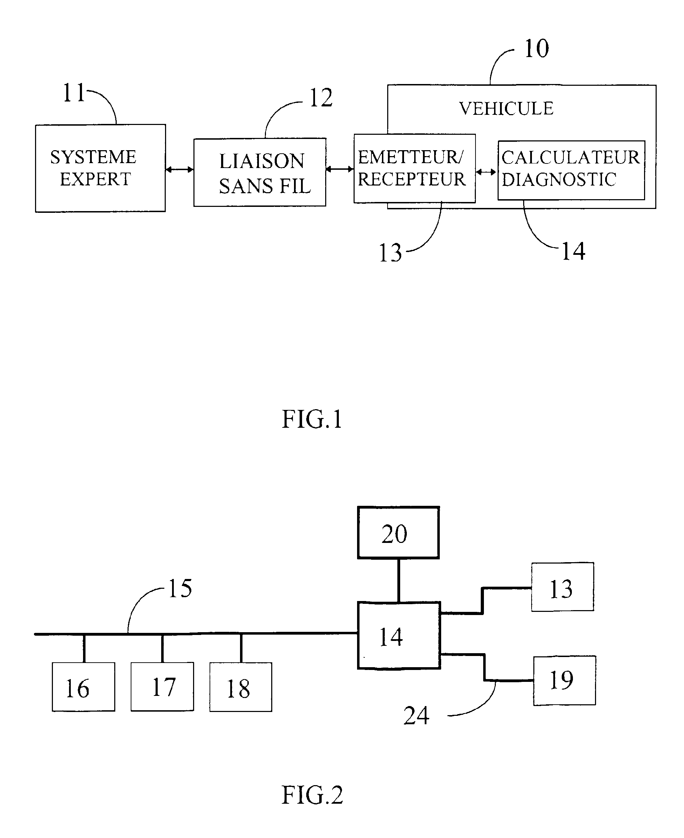

Sur la figure 1, la référence 10 représente un véhicule comportant un calculateur de diagnostic 14 dédié au diagnostic de différents composants du véhicule 10. Ce calculateur de diagnostic 14 est relié à un système d'émission/ réception 13 lui permettant d'établir une liaison bilatérale 12 avec un système expert 11 situé à distance, afin d'échanger des données avec ce dernier. Le système expert 11 consiste en un calculateur, relié à des moyens d'émission et de réception de signaux, et pouvant traiter les données qui lui sont transmises selon une programmation interne, et qui peut, par le biais d'une interface homme/machine, éventuellement recevoir des instructions d'une tierce personne, par exemple d'un réparateur.

La transmission de données entre le véhicule 10 et le système expert 11 peut être réalisée par une liaison satellite 12, ou une liaison empruntant des relais terrestres 12. En Europe, le véhicule peut emprunter, par exemple, le réseau habituellement utilisé par les mobiles de télécommunications, soit le GSM ou Global System for Mobile communication, dont l'équivalent américain et le CDPD ou Cellular Data Packet Data.

Les figures 2,3 et 4 représentent des architectures possibles du système équipant le véhicule 10 permettant de mettre en oeuvre le procédé selon l'invention. Les éléments communs sur les différentes architectures sont représentés par une même référence.

Sur la figure 2, le calculateur de diagnostic 14 est relié à différents calculateurs 16, 17, 18, montés sur le véhicule 10, par une liaison spécifique 15, appelée bus diagnostic. Les calculateurs pouvant être embarqués sur un véhicule 10 sont, par exemple, le calculateur d'injection 16, le calculateur de cabine 17 et le calculateur 18 contrôlant le système d'anti-blocage des roues. Chacun de ces calculateurs 16,17,18 comportent un microprocesseur relié à une zone de mémoire, et à une interface qui lui permet de transmettre et de recevoir des données via le bus diagnostic 15. De plus, les calculateurs 16,17,18 comportent des moyens d'autodiagnostic qui leur permettent de garder en mémoire leurs défauts. La détection d'une anomalie par un calculateur est, par exemple, réalisée en comparant des valeurs particulières, comme une pression ou une température, mesurées par celui-ci, à des valeurs de seuil conservées en mémoire. Lorsque la valeur mesurée dépasse la valeur de seuil, le calculateur 16,17,18 conclut à une anomalie dont il conserve une trace dans sa zone mémoire.

Le calculateur de diagnostic 14 peut aussi être connecté à d'autres types de capteurs, équipant le véhicule 10, et possédant un système d'autodiagnostic interne et pouvant se connecter au bus diagnostic 15.

Les protocoles utilisés pour la transmission de données sur le bus diagnostic 15 peuvent correspondre, de façon classique, aux standards CAN (Controller Area Network), KWP2000 ou J1587, les données échangées étant alors sous la forme de trames diagnostic.

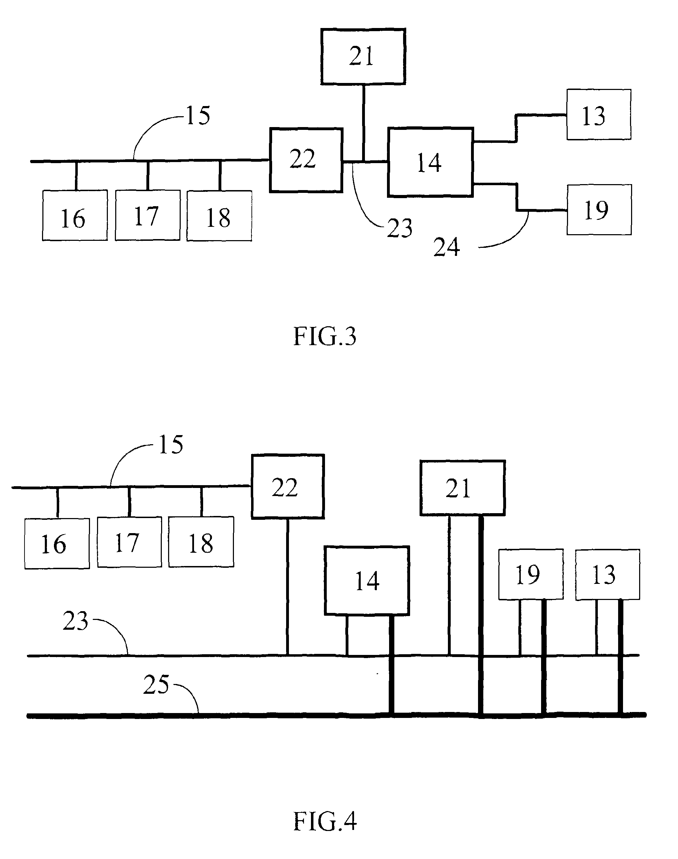

Le calculateur de diagnostic 14 comprend un microprocesseur relié à une zone de mémoire. Des moyens d'interface 20,21 entre le calculateur de diagnostic 14 et le conducteur du véhicule peuvent consister en une interface 20 directement reliée au calculateur de diagnostic 14, ou de façon plus générale, comme indiqué sur les figures 3 et 4, en un terminal 21 connecté sur le bus véhicule 23.

Le calculateur de diagnostic est par ailleurs relié à un système émetteur/récepteur de signaux 13. Ce système peut être du type communiquant par une liaison satellite, par exemple ou bien communiquant par radiofréquences, par exemple GSM (Global System for Mobile communication) ou CDPD (Cellular Data Packet Data). Le protocole utilisé sur une telle liaison peut être un protocole du type PPP, ou SMS, ou tout protocole standard de communication adapté. Le protocole utilisé sur le bus 24, reliant le calculateur diagnostic 14 et le système émetteur/récepteur est, de façon classique, un protocole du type RS232, ou tout autre protocole standard de communication adapté.

Enfin, le calculateur de diagnostic 14 est capable de recevoir des données issues d'un système de localisation 19, par exemple du type GPS (Global Position System), qui utilise les liaisons satellites pour déterminer la position du véhicule.

La figure 3 représente une architecture similaire à celle de la figure 2, dans laquelle un second calculateur 22, appelé calculateur garde-barrière, est interposé entre le calculateur diagnostic 14 et les différents calculateurs 16,17,18 équipant le véhicule 10. Ce calculateur garde-barrière 22 assure la liaison entre le bus diagnostic 15 et le bus véhicule 23. Il isole le véhicule 10 du monde extérieur. Il peut, en outre, réaliser la transposition entre le protocole utilisé sur le bus diagnostic 15 et celui utilisé sur le bus véhicule 23, ce dernier étant classiquement du type J1587 ou CAN. Dans le cas où les bus diagnostic 15 et véhicule 23 possèdent les mêmes protocoles, ce calculateur 22 devient optionnel, et n'assure que la fonction de garde-barrière, qui peut être éventuellement directement intégrée au calculateur de diagnostic 14.

La figure 4 représente une seconde variante d'architecture possible. Celle-ci propose la mise en place en parallèle du bus véhicule 23 traditionnel, d'un bus 25, dit bus rapide. Le bus véhicule 23 permet la transmission de données suivant des protocoles traditionnels de transmission de données, tels que CAN, J1587, ou RS232, et permet la transmission de données relativement complexes, comme des suites d'instructions. Le bus rapide 25, lui, est dédié à la transmission de types particuliers de données, comme par exemple, des simples valeurs numériques (images, sons, données).

Le diagnostic du véhicule est réalisé de la façon suivante. A la suite d'une panne, le conducteur du véhicule 10 prend l'initiative de se connecter au système expert 11. La communication avec le système expert 11 peut être réalisée de façon automatique, sur appui d'un bouton par exemple. Dans le cas d'une communication utilisant les liaisons téléphoniques, le numéro de téléphone correspondant au système expert 11 peut être mémorisé. La communication peut aussi être établie de façon manuelle par le conducteur. Les appels peuvent être dirigés vers un premier centre serveur qui, d'après la position géographique du véhicule 10, obtenue par le système de localisation 19, retransmet automatiquement l'appel vers le système expert 11 le plus proche, ou bien communique au conducteur, le numéro du système expert 11 le plus proche.

Une fois la communication avec le système expert 11 concerné établie, le diagnostic du véhicule 10 proprement dit peut débuter.

La première étape consiste à récupérer toutes les données concernant l'identification du véhicule 10, celles-ci pouvant être stockées dans la zone mémoire du calculateur de diagnostic 14. Eventuellement, l'identité du conducteur peut aussi être récupérée, dans le cas, par exemple, où le véhicule 10 est fourni par une société de location. L'identification du conducteur peut être un code entré manuellement par les moyens d'interface homme/machine 20,21 relié au calculateur de diagnostic 14, ou par lecture automatique d'une carte que le conducteur introduit manuellement dans un réceptacle adapté des moyens d'interface homme/machine 20,21.

La seconde étape consiste en la récupération, par le système expert 11, de tous les défauts mémorisés dans le calculateur de diagnostic 14. Préférentiellement, celui-ci enregistre en permanence les défaillances qui peuvent être signalées par les différents calculateurs 16,17,18 et, le cas échéant les capteurs. Toutefois, il peut aussi interroger successivement, suite à l'établissement de la communication avec le système expert 11, les différents calculateurs 16,17,18.

Les différents défauts rapatriés sont analysés par le système expert 11. L'analyse peut être réalisée de façon automatique suivant le principe de déroulement d'arbres de résultats de tests. Le système expert 11 peut être relié à une base de données de documentation qui permettra, par exemple, en fonction de l'identification du véhicule 10, d'obtenir le numéro adéquat d'une pièce à changer.

Si des détails ou des paramètres manquent, le système expert 11 peut en faire la demande suivant deux modes :
- soit directement au conducteur du véhicule 10, par l'intermédiaire des moyens d'interface homme/machine 20,21. Celui-ci pourra répondre aux différentes questions et pourra faire des manipulations complémentaires comme la mise en route du moteur, la stabilisation de celui-ci à un certain régime, etc...
- soit directement au calculateur de diagnostic 14 par l'intermédiaire de suites d'instructions qui permettent la lecture de données à partir d'une base de données interne à l'ordinateur de diagnostic 14 (située dans la zone mémoire du calculateur de diagnostic 14) ou de compléter cette base de données par des appels à des fonctions de diagnostic du calculateur de diagnostic 14 via le bus diagnostic 15 pour récupérer une valeur bien précise se trouvant dans la zone mémoire d'un calculateur 16,17,18 équipant le véhicule 10 (par exemple le calculateur d'injection).

Il est possible d'envisager que le système expert 11 puisse interroger le calculateur de diagnostic 14 sans que le conducteur du véhicule 10 ait établi de communication. Dans ce cas, les données demandées par le système expert 11 peuvent servir afin de réaliser une maintenance préventive, par exemple, en réalisant des statistiques sur différents paramètres véhicules, comme des moyennes de consommation, le nombre de kilomètres effectués, etc...

Lorsque le système expert 11 interroge le calculateur de diagnostic 14 pour obtenir une donnée particulière concernant un calculateur spécifique 16,17,18, le déroulement du dialogue est le suivant: le calculateur de diagnostic 14 reçoit du système expert 11 l'ordre d'initialiser un calculateur spécifique 16,17,18 équipant le véhicule 10. Cette initialisation est réalisée, de façon classique suivant le standard de transmission de données utilisé sur les bus de diagnostic 15. Par exemple, pour le standard KWP200, l'initialisation d'un calculateur spécifique 16,17,18 est réalisée, entre autre, à l'aide des paramètres suivants: l'adresse du calculateur 16,17,18 à initialiser, le type d'initialisation envisagé, les mots-clefs associés au calculateur 16,17,18, et d'autres caractéristiques propres au calculateur 16,17,18. Le système expert 11 attend alors une confirmation de connexion de la part du calculateur de diagnostic 14. Si aucune réponse ne parvient pendant une durée déterminée, le système expert 11 renouvellera son interrogation un nombre de fois déterminé.

Le calculateur de diagnostic 14 peut posséder sa propre base de données internes, relatives aux différents calculateurs 16,17,18 équipant le véhicule 10, se composant des adresses, et autres caractéristiques concernant chaque calculateur 16,17,18. Toutefois, le système expert 11 peut, lui aussi, avoir sa propre base de données contenant toutes les caractéristiques des différents calculateurs 16,17,18 du véhicule 10. Lorsque le calculateur spécifique 16,17,18 est initialisé, le calculateur de diagnostic 14 se met en attente d'un ordre provenant du système expert 11, et, dans l'attente de cet ordre, envoie au bout de laps de temps déterminé, une demande pour confirmer l'initialisation du calculateur interrogé 16,17,18. Une procédure de déconnexion automatique peut être prévue si le système expert 11 ne fait plus de requête au bout d'une certaine durée.

Il est possible d'envisager que le calculateur de diagnostic 14 puisse récupérer de façon régulière des données mémorisées dans les différents calculateurs 16,17,18, sans qu'une connexion ne soit établie avec le système expert 11, ces données étant de nature autre que les défaillances enregistrées par les calculateurs 16,17,18. Il peut s'agir, par exemple, par exemple une valeur de kilométrage ou de consommation. Avec de telles données, le calculateur de diagnostic 14 peut réaliser des calculs complémentaires, ainsi que des comparaisons avec des seuils mémorisés dans sa zone de mémoire, et ainsi détecter des défauts au même titre que les calculateurs 16,17,18. Les différentes valeurs calculées par le calculateur de diagnostic 14 peuvent être récupérées par le système expert 11, lorsque celui-ci interroge le calculateur de diagnostic 14, pour la réalisation de statistiques par exemple.

Finalement, il est possible d'envisager que le calculateur de diagnostic 14 soit à l'origine de l'établissement de la communication avec le système expert 11. Ceci peut avoir lieu dans le cas où le calculateur de diagnostic 14 détecte une défaillance signalée par les différents calculateurs 16,17,18 et, le cas échéant les capteurs, défaillance ne provoquant pas une panne du véhicule, et par conséquent non détectée par le conducteur, ou bien dans le cas où le calculateur de diagnostic 14 après avoir réalisé lui-même des calculs supplémentaires conclut à une défaillance.

Un avantage du principe de communication, suivant la présente invention, entre le calculateur de diagnostic 14 et le système expert 11, est que le système expert 11 est indépendant des caractéristiques liées au standard utilisé sur le bus diagnostic 15. En effet, le calculateur de diagnostic 14 gère lui-même la connexion et ne fait qu'attendre les ordres du système expert 11.

La présente invention s'avère particulièrement adaptée pour les sociétés de location de véhicule, qui peuvent avoir leur propre service de maintenance, mais aussi, pour toute société possédant un nombre important de véhicule. En effet, la présente invention permet, d'une part, d'améliorer les conditions de réparation d'une panne survenue sur l'un des véhicules, mais aussi, d'autre part, d'assurer une maintenance préventive d'une flotte de véhicule, en détectant, à l'avance, des anomalies relevées par des calculateurs équipant le véhicule, et qui précédent une panne éventuelle.

La présente invention n'est nullement limitée au mode de réalisation décrit et illustré qui n'a été donné qu'à titre d'exemple. Au contraire, l'invention comprend tous les équivalents techniques des moyens décrits ainsi que leurs combinaisons si celles-ci sont effectuées suivant son esprit.

## Revendications

1. Procédé de diagnostic d'un véhicule (10) par un système expert (11) situé à distance, le véhicule (10) comportant au moins un calculateur (16,17,18) possédant un microprocesseur et une zone de mémoire, le microprocesseur étant adapté pour détecter une anomalie lors de son fonctionnement et stocker des données, représentatives de ladite anomalie, dans la zone de mémoire, le calculateur (16,17,18) comportant en outre des moyens d'interface pour l'échange de données avec un bus diagnostic (15), le véhicule (10) comportant en outre des premiers moyens d'émission et de réception de signaux (13), le système expert (11) comportant un calculateur relié à des seconds moyens d'émission et de réception, caractérisé en ce que le procédé comprend les étapes suivantes :
- l'interrogation par un calculateur de diagnostic (14), monté sur le véhicule (10), du calculateur (16,17,18) équipant le véhicule via le bus diagnostic (15),
- la transmission des données représentatives de l'anomalie détectée par le calculateur (16,17,18), au calculateur de diagnostic (14), via le bus diagnostic (15),
- l'établissement d'une communication entre le calculateur de diagnostic (14) et le système expert (11) par le biais des premier (13) et second moyens d'émission et de réception de signaux,
- la transmission des données, par le calculateur de diagnostic (14), au système expert (11), via les premier (13) et second moyens d'émission et de réception de signaux,
- l'élaboration d'un diagnostic par le système expert (11) à partir desdites données.

2. Procédé de diagnostic selon la revendication 1, caractérisé en ce qu'il comprend, en outre, les étapes suivantes :
- la transmission par le système expert (11) d'une requête au calculateur de diagnostic (14), via les premier (13) et second moyens d'émission et réception de signaux, afin d'interroger le calculateur (16,17,18) équipant le véhicule pour obtenir des données spécifiques complémentaires,
- l'interrogation, par le calculateur de diagnostic (14), du calculateur (16,17,18), via le bus diagnostic (15),
- la transmission par le calculateur (16,17,18), au calculateur de diagnostic (14), des données spécifiques complémentaires via le bus diagnostic (15),
- la transmission des données spécifiques complémentaires, par le calculateur de diagnostic (14), au système expert (11), via les premier (13) et second moyens d'émission et de réception de signaux.

3. Procédé de diagnostic selon l'une des revendications 1 ou 2, caractérisé en ce qu'il comprend, en outre, les étapes suivantes :
- la demande de données spécifiques complémentaires, par le système expert (11), au calculateur de diagnostic (14), via les premier (13) et second moyens d'émission et de réception de signaux,
- la transmission de cette demande au conducteur du véhicule, au moyen d'une interface (20,21) homme/machine,
- la transmission, via les premier (13) et second moyens d'émission et de réception de signaux, au système expert (11), des données spécifiques complémentaires entrées par le conducteur au moyen de l'interface homme/machine (20,21).

4. Procédé de diagnostic selon l'une des revendications 1 à 3, caractérisé en ce que le calculateur de diagnostic (14) n'interroge le calculateur (16,17,18) pour récupérer les données relatives à des anomalies de fonctionnement, et/ou des données complémentaires, que lorsque la communication entre le calculateur de diagnostic (14) et le système expert (11) est établie.

5. Procédé de diagnostic selon l'une des revendications 1 à 3, caractérisé en ce que le calculateur diagnostic (14) peut interroger un calculateur (16,17,18) pour récupérer les données relatives à des anomalies de fonctionnement, et/ou des données complémentaires, à tout moment.

6. Procédé de diagnostic selon l'une des revendications 1 à 5, caractérisé en ce que l'établissement de la communication, entre le calculateur de diagnostic (14) et le système expert (11), est établi par le conducteur du véhicule (10).

7. Procédé de diagnostic selon l'une des revendications 1 à 5, caractérisé en ce que l'établissement de la communication, entre le calculateur de diagnostic (14) et le système expert (11), est établi par le système expert (11).

8. Procédé de diagnostic selon l'une des revendications 1 à 5, caractérisé en ce que l'établissement de la communication, entre le calculateur de diagnostic (14) et le système expert (11), est établi par le calculateur de diagnostic (14).

9. Dispositif de diagnostic d'un véhicule (10), le véhicule comportant au moins un calculateur (16,17,18) possédant un microprocesseur et une zone de mémoire, le microprocesseur étant adapté pour détecter une anomalie lors de son fonctionnement et stocker des données, représentatives de ladite anomalie, dans la zone de mémoire, le calculateur (16,17,18) comportant en outre des moyens d'interface pour l'échange de données avec un bus diagnostic (15), caractérisé en ce qu'il comprend un calculateur de diagnostic (14) relié d'une part au calculateur (16,17,18) via le bus diagnostic (15), et d'autre part à des moyens d'émission et de réception (13) de signaux, et adapté pour recevoir les données issues du calculateur (16,17,18), via le bus diagnostic (15), et les configurer pour les émettre par les moyens d'émission et de réception (13), et adapté pour recevoir des signaux reçus par les moyens d'émission de réception (13) et de les configurer en demande de données complémentaires qu'il transmet, via le bus diagnostic (15), au calculateur (16,17,18).

10. Dispositif de diagnostic selon la revendication 9, caractérisé en ce que le calculateur de diagnostic (14) est, en outre, relié à des moyens d'interface homme machine (20,21) par lesquels le conducteur du véhicule (10) peut envoyer les données complémentaires suite à une demande du calculateur de diagnostic (14).
